# EUROPEAN PATENT APPLICATION

(11) **EP 4 628 838 A1**
(43) Date of publication of application: **08.10.2025**
(21) Application number: 24909240.4
(22) Date of filing: 07.11.2024
(51) Int. Cl.: G01B 11/08, G01B 11/03, G01B 11/02, G06T 7/00, G06T 7/10, G06T 7/30, H01L 21/66

(54) **HOLE INSPECTION SYSTEM AND METHOD**

(30) Priority: 28.12.2023 KR 20230195777
(71) Applicant: Yas Co., Ltd., Paju-si, Gyeonggi-do 10857 (KR)
(72) Inventor: KIM, Hyung Su, Paju-si, Gyeonggi-do 10857 (KR); KIM, Hyo Jun, Paju-si, Gyeonggi-do 10857 (KR)
(74) Representative: Isarpatent
(86) International application number: PCT/KR2024/017478
(87) International publication number: WO 2025/143521

(57) **Abstract**

The present invention relates to a hole inspecting system and method, and more particularly, to a system and method for inspecting a shape and a position of a via hole formed in a substrate. According to an embodiment, a hole inspecting system for a substrate provided with a hole includes a substrate support device that supports the substrate, a camera disposed above or below the substrate to acquire an image of the substrate, a coaxial light source disposed at the same side as the camera based on the substrate, a wide area light source that is disposed at a side opposite to the camera and radiates light onto a wider area than that of the coaxial light source, and an inspection module that inspects the hole based on the image of the substrate acquired by the camera.

## Description

### [Technical Field]

The present invention relates to a hole inspecting system and method, and more particularly, to a system and method for inspecting a shape and a position of a via hole formed in a substrate.

### [Background Art]

Recently, to improve the degree of integration of a device, next-generation processing-in-memory (PIM) semiconductors are being developed, and for this purpose, a glass substrate with a large area is being used. To this end, a system and method for inspecting a via hole formed in a substrate is required.

In this regard, according to Japanese Patent Registration No. 3859446 titled "Semiconductor substrate inspecting device and semiconductor substrate inspecting method," a technology for inspecting a via hole by sequentially applying a plurality of DC voltages having different voltage values to a semiconductor substrate is disclosed.

This existing technology is a technique capable of being applied after a conductor is processed in the via hole and thus has a limitation in that this technology is insufficient for inspecting the via hole itself, for example, a shape and a position of the via hole.

Meanwhile, the above-described background technology constitutes technical information that an inventor possesses to derive the present invention or acquires during a process of deriving the present invention and is not necessarily a widely known technology disclosed to the general public prior to the filing of the application of the present invention.

### [Description of Invention]

### [Technical Problem]

A problem to be solved by the present invention is to shorten an inspection time and improve accuracy in inspecting a via hole formed in a substrate.

A problem to be achieved by the present invention is to accurately and quickly perform an inspection related to inspecting at least one of an inner diameter, an outer diameter, and a position of a via hole formed in a substrate.

A problem to be solved by the present invention is to establish a low-cost and high-efficiency system for inspecting a via hole formed on a substrate.

The aspects of the present invention are not limited to the aspects described above, and those skilled in the art will clearly understand other aspects not described from the following description.

### [Technical Solution]

According to one embodiment of the present invention to solve the above-described problems, a hole inspecting system for a substrate provided with a via hole includes a substrate support device that supports the substrate, a camera disposed above or below the substrate to acquire an image of the substrate, a coaxial light source disposed at the same side as the camera based on the substrate, a wide area light source that is disposed at a side opposite to the camera and radiates light onto a wider area than that of the coaxial light source, and an inspection module that inspects the via hole based on the image of the substrate acquired by the camera.

The hole inspecting system according to an embodiment may further include a camera moving module that supports the camera while the camera is spaced a predetermined distance from the substrate and allows the camera to reciprocate in a first direction parallel to the substrate, wherein the substrate support device may further include a substrate moving module that is parallel to the substrate and moves the substrate in a second direction perpendicular to the first direction.

In the hole inspecting system according to the embodiment, the substrate moving module may include a plurality of linear driving modules that are arranged at both sides of the substrate and linearly move the substrate.

In the hole inspecting system according to the embodiment, the wide area light source may include a line light source installed to extend to be parallel to a first direction in which the camera reciprocates.

In the hole inspecting system according to the embodiment, the line light source may radiate light onto an area that is (a length corresponding to a width of the substrate)*(a width corresponding to an FOV of the camera).

In the hole inspecting system according to the embodiment, the wide area light source may include a surface light source that radiates light to an area corresponding to an entire area of the substrate.

In the hole inspecting system according to the embodiment, the inspection module may include an image processing unit that processes the image of the substrate based on a global mark corresponding to one point of the substrate and an alignment mark corresponding to each corner of one group formed by the via hole.

In the hole inspecting system according to the embodiment, the image processing unit may inspect at least one of a position of the one group and a position of the via hole included in the one group based on the global mark and the alignment mark.

In the hole inspecting system according to the embodiment, the global mark and the alignment mark may be formed by radially arranging a plurality of points or circles, and the image processing unit may correct the image of the substrate by determining whether the image of the substrate is distorted based on the global mark and the alignment mark.

In the hole inspecting system according to the embodiment, the camera may acquire a plurality of images obtained by dividing the substrate into predetermined areas, and the image processing unit may acquire an image of the entire substrate by merging the plurality of divided images based on the global mark and the alignment mark.

In the hole inspecting system according to the embodiment, the image processing unit may perform affine transformation on the plurality of divided images based on the global mark and the alignment mark, merge the images to match with a computer-aided design (CAD), and thus acquire the image of the entire substrate.

In the hole inspecting system according to the embodiment, the camera may acquire the image of the substrate including both an inner diameter and an outer diameter of the via hole, and the inspection module may determine whether the via hole is good based on the image of the substrate.

In the hole inspecting system according to the embodiment, in the image of the substrate, a difference between gray levels inside and outside a boundary area of an inner diameter may be 10 or more.

According to one embodiment of the present invention to solve the above-described problems, a hole inspecting method, which is performed by the hole inspecting system, includes radiating light onto a substrate using a coaxial light source disposed at the same side as a camera based on the substrate and a wide area light source that is disposed at a side opposite to the camera and radiates light onto a wider area than that of the coaxial light source, acquiring an image of the substrate using the camera, and inspecting a via hole based on the acquired image of the substrate.

In the hole inspecting system according to an embodiment, the inspecting may include correcting the image of the substrate based on a global mark corresponding to one point of the substrate and an alignment mark corresponding to each corner of one group formed by the via hole and inspecting whether the via hole is good based on the corrected image of the substrate.

### [Advantageous Effects]

According to any one solution for problems of the present invention, in inspecting a via hole formed on a substrate, an inspection time can be shortened, and accuracy can be improved.

According to any one solution for problems of the present invention, in inspecting at least one of an inner diameter, an outer diameter, and a position of a via hole formed in a substrate, the inspection can be accurately and quickly performed.

According to any one solution for problems of the present invention, in inspecting a via hole formed on a substrate, a low-cost and high-efficiency system can be established.

The effects obtained in the present invention are not limited to the effects described above, and other effects not described will be clearly understood by those skilled in the art to which the present invention pertains from the above detailed description.

### [Description of Drawings]

FIG. 1 is a cross-sectional view illustrating an example of a via hole formed in a substrate.
FIG. 2 is an exemplary view of an image of a substrate according to an embodiment of the present invention.
FIG. 3 is a side view for describing a hole inspecting system according to an embodiment of the present invention.
FIG. 4 is an exemplary view of a substrate having a plurality of via holes according to an embodiment of the present invention.
FIG. 5 is a top view for describing the hole inspecting system according to the embodiment of the present invention.
FIGS. 6 and 7 are exemplary views for describing a light source of the hole inspecting system according to the embodiment of the present invention.
FIG. 8 is a flowchart for describing a hole inspecting method according to an embodiment of the present invention.

### [Best Mode]

Advantages and features of the present invention and a method of achieving the advantages and the features will become apparent with reference to embodiments described below in detail together with the accompanying drawings. However, the present invention is not limited to embodiments disclosed below but will be implemented in various different forms. The present embodiments are provided merely to fully inform the scope of the present invention of those skilled in the art to which the present invention pertains by ensuring that the disclosure of the present invention is complete. That is, the present invention is merely defined by the scope of the appended claims.

A shape, a size, a ratio, an angle, a number, and the like disclosed in the drawings to describe the embodiments of the present invention are exemplary, and thus the present invention is not limited to the illustration. Further, in the description of the present invention, when it is determined that the detailed description of widely known related technologies may make the subject matter of the present invention unnecessarily unclear, the detailed description will be omitted. When the wording "include," "have," or "consist of" mentioned in the specification is used, other parts may be added unless "only" is used. A component expressed in a singular form includes a plurality of components unless specifically stated.

The component is interpreted to include a range of error even when there is no explicit description.

Although terms such as first and second are used to describe various components, these components are not limited by these terms. These terms are only used to distinguish one component from another component. Thus, a first component mentioned below may be a second component within the technical spirit of the present invention.

The same reference numerals refer to the same components throughout the specification unless otherwise stated.

Features of the various embodiments of the present invention may be partially or entirely coupled and combined to each other, technically various interlocking and driving that may be fully understood by those skilled in the art are made possible, and the embodiments may be implemented independently of each other or may be implemented together in a corresponding relationship.

Hereinafter, the present invention will be described in detail with reference to the accompanying drawings.

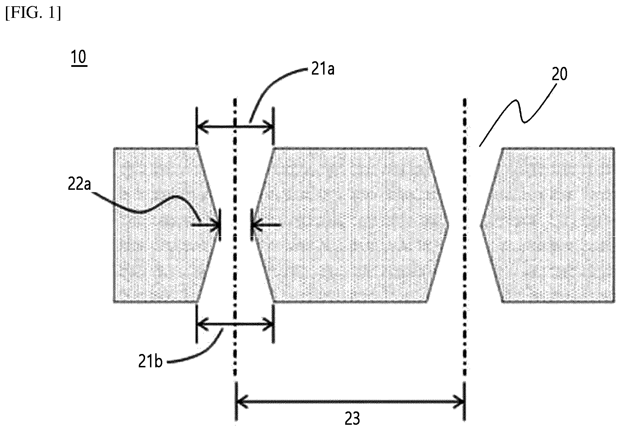

First, FIG. 1 is a cross-sectional view illustrating an example of a via hole 20 formed in a substrate 10. Referring to FIG. 1, a cross section of the via hole 20 according to the embodiment may include an upper diameter 21a and a lower diameter 21b and include a waist diameter 22a. Further, via holes 20 may be spaced a certain distance from each other, and in this case, a distance 23 between the via holes 20 may be defined as a distance between centers of the via holes 20.

According to FIG. 1, a cross-section of the via hole 20 formed in the substrate 10 may be formed in an hourglass shape having both wide ends and a narrow center, but may be implemented in various forms such as a tapered shape or a circular column shape according to the embodiment.

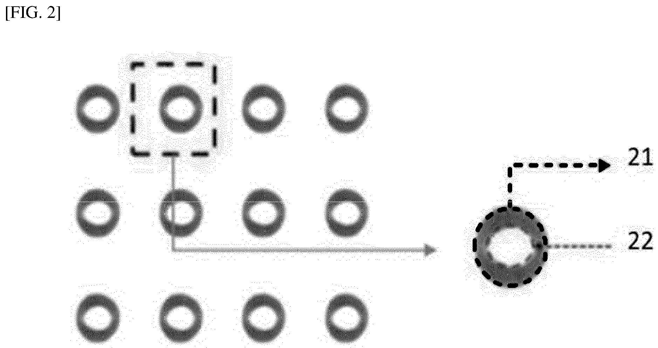

Further, FIG. 2 is an exemplary view of an image of the substrate 10 according to the embodiment of the present invention. Referring to FIG. 2, the image of the substrate 10 observed from an upper side or a lower side of the substrate 10 includes an image of the via hole 20. According to FIG. 2, the via hole 20 may be implemented in a circular shape, but may be implemented in various shapes such as an elliptic shape and a quadrangular shape according to the embodiment.

Referring to FIGS. 1 and 2, the upper diameter 21a and the lower diameter 21b of the via hole 20 correspond to a vertical outer diameter 21 of the via hole 20. Further, the waist diameter 22a of the via hole 20 corresponds to an inner diameter 22 of the via hole 20. In this case, based on the via hole 20, the substrate 10 may be divided into an outer area of the outer diameter 21, a tapered area between the outer diameter 21 and the inner diameter 22, and a cavity area inside the inner diameter 22. In this case, since reflectance of radiated light is changed due to influences of morphological characteristics of the areas, a system for identifying and inspecting the inner diameter 22 and the outer diameter 21 of the via hole 20 is disclosed.

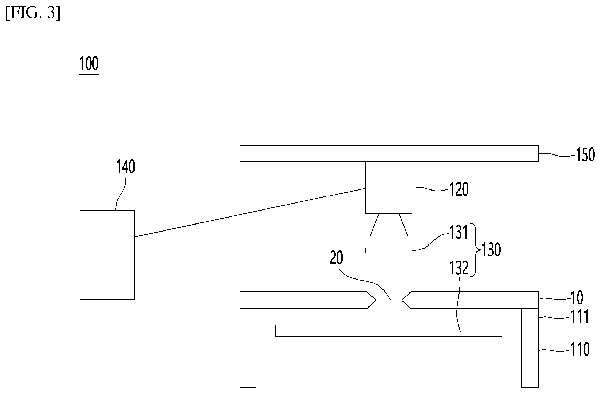

In this regard, FIG. 3 is a side view for describing a hole inspecting system 100 according to an embodiment of the present invention. Referring to FIG. 3, the hole inspecting system 100 is for inspecting the via hole 20 formed in the substrate 10, and for example, may inspect the plurality of via holes 20 formed in the large-area glass substrate 10 for a processing-in-memory (PIM) semiconductor.

According to an embodiment, the hole inspecting system 100 may include a substrate support device 110 that supports the substrate 10, a camera 120 disposed above or below the substrate 10 to acquire an image of the substrate 10, a light source 130 that radiates light onto the substrate 10, and an inspection module 140 that inspects the via hole 20 based on the image acquired by the camera 120.

In this case, the substrate support device 110 is configured to support the substrate 10 while in contact with the substrate 10 during a process of inspecting the via hole 20, may support both sides of the substrate 10 according to the embodiment, and for example, may support an edge area of the substrate 10, in which the via hole 20 is not disposed.

According to the embodiment, the substrate support device 110 may include a substrate moving module 111, and the substrate moving module 111 may move the substrate 10 according to a process. Details of the movement of the substrate 10 will be described below in a related section.

Next, the camera 120 is disposed above or below the substrate 10 to acquire the image of the substrate 10, and FIG. 3 illustrates an example in which the camera 120 is disposed above the substrate 10.

In this regard, the camera 120 may be provided as a line scan camera, such as a tdi line scan camera, and accordingly, the image of the substrate 10 may be quickly scanned and obtained.

To this end, the camera 120 may be moved by a camera moving module 150 to acquire an image of the entire area of the substrate 10. To this end, the camera moving module 150 may support the camera 120 while the camera 120 is spaced a predetermined distance from the substrate 10 and may move the camera 120 according to progress of the process.

In this case, the hole inspecting system 100 should acquire the image of the substrate 10 and acquire an image of the via hole 20 by which the via hole 20 may be identified to enable the inspection of the via hole 20. In detail, the image of the substrate 10 in which a difference between gray levels inside and outside a boundary area between the inner diameter 22 and the outer diameter 21 is 10 or more should be acquired to identify and inspect the outer diameter 21 and the inner diameter 22 of the via hole 20. Here, the gray level refers to a value obtained by dividing luminance of each pixel on the image into 256 gray scales from 0 to 255 when the image of the substrate acquired through the camera 120 is digitized.

That is, the hole inspecting system 100 may inspect the inner diameter 22 by acquiring the image of the substrate 10 in which a difference between the gray levels inside and outside a boundary area of the inner diameter 22 is 10 or more and may inspect the outer diameter 21 by acquiring the image of the substrate 10 in which a difference between the gray levels inside and outside a boundary area of the outer diameter 21 is 10 or more.

To this end, the hole inspecting system 100 may include a plurality of light sources 130. In this case, the light sources 130 may be configured to radiate light onto the substrate 10 and arranged above and below the substrate 10. In detail, the light source 130 may include a coaxial light source 131 disposed at the same side as the camera 120 based on the substrate 10 and a wide area light source 132 disposed at a side opposite to the camera 120 based on the substrate 10 to radiate light onto a wider area than that of the coaxial light source 131. In this case, the wide area light source 132 may be disposed on a line perpendicular to the camera 120, and the coaxial light source 131 and the wide area light source 132 may provide light having robust straightness to the substrate 10.

For example, as illustrated in FIG. 3, when the camera 120 is disposed above the substrate 10, the coaxial light source 131 may be disposed above the substrate 10 to provide coaxial light for the camera 120 onto the substrate 10. Further, the wide area light source 132 may be disposed at a lower side of the substrate 10, which is a side opposite to the camera 120 based on the substrate 10, to radiate light onto the wider area than that of the coaxial light source 131.

The light emitted through these two light sources 130 may pass through the via hole 20 to form an optical image through an optical phenomenon such as a diffraction phenomenon and an interference phenomenon with refracted beams. Accordingly, the camera 120 may acquire the image of the substrate 10 including the image of the via hole 20 sufficiently to inspect a shape, a position, or the like of the via hole 20. In detail, an optical image may be acquired according to the light incident on the camera 120 through an optical phenomenon such as reflection, diffraction, and interference from the outer area of the outer diameter 21, the tapered area between the outer diameter 21 and the inner diameter 22, and the cavity area inside the inner diameter 22.

In this case, the outer area of the outer diameter 21 is the surface of the substrate 10 and has high reflectance for the radiation light incident perpendicular to the surface of the substrate 10, but the tapered area between the outer diameter 21 and the inner diameter 22 is inserted and inclined with respect to the surface of the substrate 10 and thus has relatively low reflectance for the radiation light. Due to this difference between the reflectances, the inner area and the outer area based on the outer diameter 21 have a significantly different gray level related to the image, and thus the outer diameter 21 may be identified only by the radiation light of the coaxial light source 131. On the other hand, the tapered area between the outer diameter 21 and the inner diameter 22 has low reflectance for the radiation light of the coaxial light source 131 due to morphological characteristics of being inserted and tilted with respect to the surface of the substrate 10, and thus it is difficult to distinguish the tapered area from the cavity area inside the inner diameter 22.

Thus, according to the embodiment, the wide area light source 132 may be disposed at a side opposite to the camera 120 and the coaxial light source 131, and thus the inner diameter 22 may be identified. That is, as the radiation light of the wide area light source 132 passes through the via hole 20 and is incident on the camera 120, there is a difference between the gray levels of the tapered area between the outer diameter 21 and the inner diameter 22 and the cavity area inside the inner diameter 22, and thus the inner diameter 22 may be identified.

Accordingly, the hole inspecting system 100 may acquire the image of the substrate 10 in which a difference between the gray levels inside or outside a boundary line between the outer diameter 21 and the inner diameter 22 is 10 or more, and based on this, the outer diameter 21 and the inner diameter 22 are simultaneously inspected, and thus an inspection time can be shortened, and accuracy of the inspection can be improved.

In more detail, when the hole inspecting system 100 includes only one coaxial light source 131, as described above, the tapered area and the cavity area inside the inner diameter 22 in the image of the substrate 10 have a similar gray level, and thus only the outer diameter 21 can be inspected, and the inner diameter 22 cannot be inspected. In order to inspect the inner diameter 22, the coaxial light source 131 is moved to a side facing the camera 120, light is radiated under a lower portion of the substrate 10, the light passing through the cavity area inside the inner diameter 22 is collected by the camera 120, and thus the inner diameter 22 can be inspected. However, in this case, since the inspection for the outer diameter 21 and the inspection for the inner diameter 22 should be independently performed, there is a disadvantage in that the inspection time increases, and since errors occur in the two inspection processes, the accuracy of the inspection may be reduced.

On the other hand, the hole inspecting system 100 according to the present invention has an advantage in that the above problem is solved because the coaxial light source 131 and the wide area light source 132 may be used to clearly acquire a hole image for the inner diameter and the outer diameter.

Meanwhile, the inspection module 140 is configured to inspect the via hole 20 based on the image acquired by the camera 120 and may include a processor for image analysis. According to an embodiment, the inspection module 140 may determine whether the hole via 20 is good by extracting the boundary line between the inner diameter 22 and the outer diameter 21 and inspecting whether the inner diameter 22 and the outer diameter 21 of the via hole 20 are formed as well as shapes of the inner diameter 22 and the outer diameter 21. According to an embodiment, the inspection module 140 may process the image of the substrate 10 to further clarify the boundary line between the inner diameter 22 and the outer diameter 21 and thus increase a difference between the gray levels inside and outside the boundary area between the inner diameter 22 and the outer diameter 21.

Further, the inspection module 140 may determine whether the via hole 20 is good by measuring a distance between the via holes 20. For example, whether the via hole 20 is good can be determined by determining a center of the via hole 20 based on at least one of the inner diameter 22 and the outer diameter 21, measuring the distance 23 between the via holes 20 based on the center of the via hole 20, and analyzing an alignment state of the via holes 20.

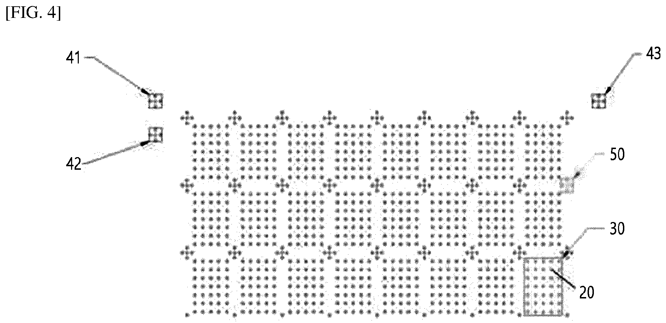

In this regard, FIG. 4 is an exemplary view of the substrate 10 having the plurality of via holes 20 according to the embodiment of the present invention. According to FIG. 4, the substrate 10 may form global marks 41, 42, and 43 corresponding to points of the substrate 10, e.g., corners of the substrate 10 and an alignment mark 50 corresponding to each corner of one group 30 formed by the plurality of via holes 20 or may be combined with separate coordinate configurations forming the global marks 41, 42, and 43 and the alignment mark 50. For example, when the one group 30 formed by the plurality of via holes 20 has a quadrangular shape, the alignment mark 50 may be formed at positions corresponding to four corners of the one group 30.

Accordingly, the inspection module 140 can measure a relative position of the alignment mark 50 based on the global marks 41, 42, and 43 and can measure a position of each via hole 20 included in the one group 30 based on the alignment mark 50.

According to the embodiment, the global marks 41, 42, and 43 and the alignment mark 50 may be formed as a plurality of points or circles that are radially arranged. For example, the global marks 41, 42, and 43 and the alignment mark 50 may be formed as a point or circle disposed at a center and a plurality of points or circles arranged at regular intervals in all directions centered on the point or circle disposed at the center.

In this regard, the inspection module 140 may include an image processing unit (not illustrated) that processes the image of the substrate 10 based on the global marks 41, 42, and 43 and the alignment mark 50.

According to the embodiment, the image processing unit may determine whether the image of the substrate 10 is distorted based on the global marks 41, 42, and 43 and the alignment mark 50. That is, positions and intervals of the global marks 41, 42, and 43 and the alignment mark 50 and distortion of the points or circles included in the global marks 41, 42, and 43 and the alignment mark 50 are measured or sizes of the points or circles included in the global marks 41, 42, and 43 and the alignment mark 50 are compared with each other. Thus, based on this, distortion, such as inclination or contortion, of the image can be discriminated and corrected.

In this case, the image processing unit may perform affine transformation that changes the entire image by changing the arrangement of pixels included in the image. For example, the distortion, such as inclination or contortion, of the image can be discriminated based on the global marks 41, 42, and 43 and the alignment mark 50, the image can be moved in parallel or rotated by changing a position of each pixel included in the image to measure a degree of the distortion and correct the distortion, and the distortion can be corrected by converting a size of the image or adjusting a ratio of the image.

Further, when the camera 120 acquires a plurality of images of the one substrate 10 divided into predetermined areas, the image processing unit can acquire an image for the entire substrate 10 by merging the plurality of images divided based on the global marks 41, 42, and 43 and the alignment mark 50. For example, the image processing unit can merge the plurality of images by determining relative positions between the plurality of images based on the global marks 41, 42, and 43 and the alignment mark 50.

Further, the image processing unit may perform affine transformation on each of the plurality of divided images based on the global marks 41, 42, and 43 and the alignment mark 50 and may merge the plurality of images. In this case, the image processing unit may perform affine transformation on each of the plurality of divided images, merge the images, and match the images to a computer-aided design (CAD). In this case, the CAD is a generic term for a CAD file itself, a CAD image obtained by converting the CAD file, and data extracted from the CAD file or the CAD image. The data extracted from the CAD file or the CAD image may include, for example, information capable of identifying relative positions between the plurality of divided images and may include coordinate information of the global marks 41, 42, and 43 and the alignment mark 50 included in the CAD file or the CAD image according to the embodiment. Accordingly, the image processing unit may perform affine transformation so that the global marks 41, 42, and 43 and the alignment mark 50 included in the plurality of images are matched with the global marks 41, 42, and 43 and the alignment mark 50 included in the CAD, merge them, and thus obtain the image for the entire substrate 10.

Accordingly, the inspection module 140 may determine whether the via hole 20 is good based on the image of the substrate 10. For example, the inspection module 140 may determine whether the position of the via hole 20 is suitable based on the image of the entire substrate 10. In detail, the inspection module 140 may inspect a position of the one group 30 formed by the plurality of via holes 20 based on the image of the entire substrate 10. In this case, the inspection of the position of the one group 30 formed by the plurality of via holes 20 may include inspection of an alignment state of the one group 30 formed by the plurality of via holes 20, such as a position at which the one group 30 formed by the plurality of via holes 20 is formed in the substrate 10, a distance between the one groups 30, and a relative direction of the one group 30 with respect to the global marks 41, 42, and 43.

In detail, the inspection module 140 may inspect the position of each via hole 20 included in the one group 30 formed by the plurality of via holes 20, but the inspection module 140 may allocate coordinates to each via hole 20 based on the alignment mark 50 corresponding to each corner of the one group 30 and inspect the position of each via hole 20 based on the allocated coordinates. Further, the inspection module 140 can examine the alignment state of the one group 30 formed by the plurality of via holes 20 by extracting a direction component for the one group 30 formed by the plurality of via holes 20 based on the alignment mark 50 and extracting a relative direction for the global marks 41, 42, and 43 formed by the extracted direction component.

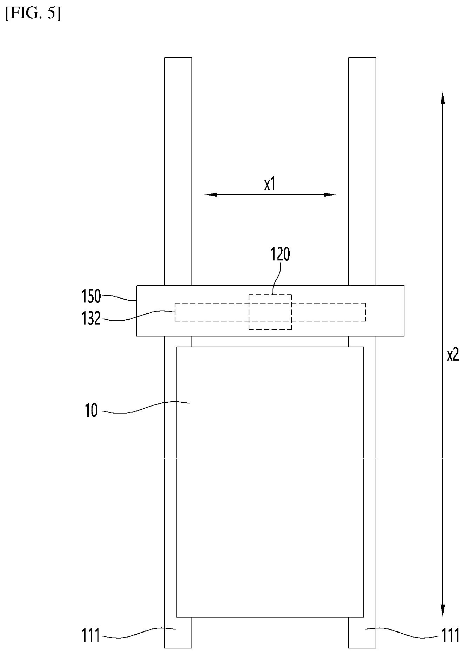

Next, FIG. 5 is a top view for describing the hole inspecting system 100 according to the embodiment of the present invention.

Referring to FIG. 5, the substrate 10 may be moved by the substrate moving module 111, and the camera 120 may be moved by the camera moving module 150 to acquire the image of the substrate 10. Further, the wide area light source 132 may be disposed at a side opposite to the camera 120 based on the substrate 10, and in this case, the wide area light source 132 may be disposed on a line perpendicular to the camera 120.

In detail, the camera moving module 150 may allow the camera 120 to reciprocate in a first direction x1 parallel to the substrate 10. Further, the substrate moving module 111 may move the substrate 10 in a second direction x2 parallel to the substrate 10 but perpendicular to the first direction x1. To this end, the substrate moving module 111 may include a plurality of linear driving modules (not illustrated) arranged at both sides of the substrate 10 to move the substrate 10. Accordingly, the camera 120 may acquire the plurality of images obtained by dividing the one substrate 10 into predetermined areas, and as a result, may quickly and simply acquire the image of the entire area of the substrate 10.

Further, the camera moving module 160 may simultaneously move the coaxial light source 131 and the camera 120 to continuously provide coaxial light while the camera 120 moves.

### [Modes of the Invention]

According to the embodiment, the wide area light source 132 may include a line light source installed to extend to be parallel to the first direction x1 in which the camera 120 reciprocates. In this case, the line light source may be disposed on the line perpendicular to the camera 120.

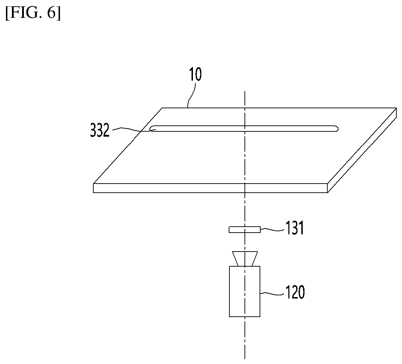

In this regard, FIG. 6 is an exemplary view for describing the light source 130 of the hole inspecting system 100 according to the embodiment of the present invention.

Referring to FIG. 6, the wide area light source 132 may be formed as a line light source 332 and may be disposed at a side opposite to the camera 120 based on the substrate 10. According to the embodiment, the line light source 332 may radiate light to an area that is (a length corresponding to a width of the substrate)*(a width corresponding to a field of view (FOV) of the camera) with respect to the substrate 10. Here, the FOV refers to a viewing angle of the camera 120.

In this case, the length corresponding to the width of the substrate 10 may be a length corresponding to any one of a horizontal width or a vertical width of the substrate 10, and according to the embodiment, may be a width of the substrate 10 in a direction parallel to the first direction x1 in which the camera 120 reciprocates on the substrate 10 or a width of an area in which the via hole 20 is formed in the substrate 10 in a direction parallel to the first direction x1.

Further, the length corresponding to the FOV of the camera 120 may be a length corresponding to an area on the substrate 10, which may be imaged at one time by the camera 120 according to the FOV of the camera 120, and for example, may be a length of an area on the substrate 10, which may be imaged at one time by the camera 120 according to the FOV of the camera 120, in a direction parallel to the second direction x2.

As described above, the line light source 332 radiates light onto an area that is (a length corresponding to the width of the substrate)*(a width corresponding to the FOV of the camera) with respect to the substrate 10, and thus the line light source 332 may radiate light onto an area of the substrate 10 corresponding to an image acquired as the camera 120 reciprocates.

In some embodiments, the wide area light source 132 may include a surface light source 432 that radiates light onto the entire area of the substrate 10.

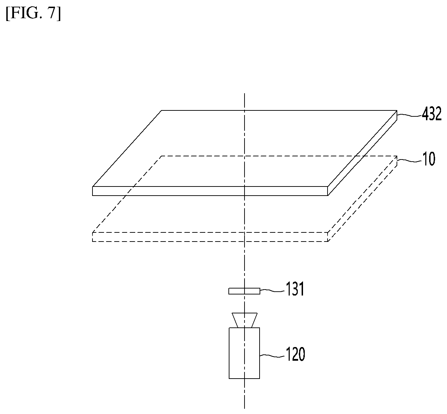

In this regard, FIG. 7 is an exemplary view for describing the light source 130 of the hole inspecting system 100 according to another embodiment of the present invention.

Referring to FIG. 7, the wide area light source 132 may be formed as the surface light source 432 and may be disposed at a side opposite to the camera 120 based on the substrate 10. In this case, the surface light source 432 may be disposed parallel to the substrate 10 on the line perpendicular to the camera 120 to radiate light onto an area corresponding to the entire area of the substrate 10.

In the embodiment of the present invention, as illustrated in FIG. 6, when the wide area light source 132 is provided as the line light source 332, light may be intensively radiated onto a relatively narrow area. Thus, light radiation performance is excellent, a clear image (i.e., an outline) of the inner diameter 22 of the via hole 20 can be acquired, and manufacturing costs of the hole inspecting system 100 can be lowered.

In the embodiment of the present invention, as illustrated in FIG. 7, when the wide area light source 130 is provided as the surface light source 432, light may be radiated onto the entire area of the substrate 10. Thus, light radiation performance may be relatively degraded, but there is no need to match a scan area of the camera 120 with a light radiation area of the wide area light source 132, and a structure of the hole inspecting system 100 can be simplified.

As described above, the hole inspecting system 100 according to the present invention includes the coaxial light source 131 that is coaxial with the camera 120 and the line light source 332 or the surface light source 432 as the wide area light source 132 disposed at a side opposite to the camera 120 based on the substrate 10, and thus the inner diameter 22 and the outer diameter 21 of the via hole 20 can be simultaneously measured.

In particular, the coaxial light source 131 is formed to be movable together with the camera 120, the line light source 332 of the wide area light source 132 radiates light onto the area that is (the length corresponding to the width of the substrate)*(the width corresponding to the FOV of the camera), and the surface light source 432 radiates light onto a front surface of the substrate 10. Thus, the inner diameter 22 and the outer diameter 21 of the via hole 20 can be quickly inspected by the movement of the coaxial light source 131 and the camera 120 without the movement of the line light source 332 or the surface light source 432.

Further, the line light source 332 or the surface light source 432 may provide sufficiently bright light such that, in the image of the substrate 10, a difference between the gray levels inside or outside the inner diameter 22 is 10 or more. Thus, an inner area (i.e., the cavity area) of the inner diameter 22 and an outer area (i.e., the tapered area) of the inner diameter 22 can be clearly distinguished. Therefore, various inspections of the via hole 20 including a shape, a size, and a position of the inner diameter 22 as well as misalignment between the inner diameter 22 and the outer diameter 21 may be performed.

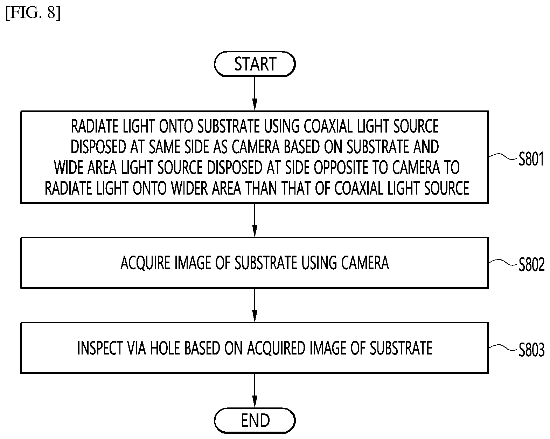

Next, FIG. 8 is a flowchart for describing a hole inspecting method according to the embodiment of the present invention.

Referring to FIG. 8, the hole inspecting method performed by the hole inspecting system 100 may radiate light onto the substrate 10 using the coaxial light source 131 disposed at the same side as the camera 120 and the wide area light source 132 disposed at a side opposite to the camera 120 based on the substrate 10 to radiate light onto a wider area than that of the coaxial light source 131(S801).

In this case, the wide area light source 132 may include the line light source 130 installed to extend to be parallel to the first direction x1 in which the camera 120 reciprocates, and according to the embodiment, the line light source 130 may radiate light to an area that is (the length corresponding to the width of the substrate 10)*(the width corresponding to the FOV of the camera 120).

In still another embodiment, the wide area light source 132 may include the surface light source 130 that radiates light onto the area corresponding to the entire area of the substrate 10.

Further, the hole inspecting system 100 may support the camera 120 while spaced a predetermined distance from the substrate 10 through the camera moving module 150 and allow the camera 120 to reciprocate in the first direction x1 parallel to the substrate 10.

Further, the hole inspecting system 100 may move the substrate 10 according to the movement of the camera 120 but may move the substrate 10 in the second direction x2 parallel to the substrate 10 and perpendicular to the first direction x1.

Further, the hole inspecting system 100 may acquire the image of the substrate 10 using the camera 120 (S802). In this case, the image of the substrate 10 may include the image of the via hole 20, and a difference between the gray levels inside and outside the boundary area of the inner diameter 22 may be 10 or more.

Further, when the hole inspecting system 100 acquires the image of the substrate 10, the camera 120 and the substrate 10 may move in the first direction x1 or the second direction x2, and thus the camera 120 may acquire the plurality of images obtained by dividing the substrate 10 into predetermined areas.

In addition, the hole inspecting system 100 may inspect the via hole 20 based on the acquired image of the substrate 10 (S803).

According to the embodiment, the hole inspecting system 100 may process the image of the substrate 10 based on the global marks 41, 42, and 43 corresponding to points of the substrate 10 and the alignment mark 50 corresponding to each corner of the one group 30 formed by the via holes 20.

In this case, the global marks 41, 42, and 43 and the alignment mark 50 may be formed on the substrate 10 itself by radially arranging a plurality of points or circles and may be formed in separate coordinate configurations and attached to the substrate 10 according to the embodiment.

According to the embodiment, the hole inspecting system 100 may correct the image of the substrate 10 by determining whether the image of the substrate 10 is distorted based on the global marks 41, 42, and 43 and the alignment mark 50 and inspect whether the via hole 20 is good based on the corrected image of the substrate 10.

For example, the hole inspecting system 100 may inspect at least one of the position of the one group 30 formed by the plurality of via holes 20 and the position of each via hole 20 included in the one group 30 based on the global marks 41, 42, and 43 and the alignment mark 50.

Further, the hole inspecting system 100 may acquire the image for the entire substrate 10 by merging the plurality of images acquired through the camera 120 and divided into predetermined areas based on the global marks 41, 42, and 43 and the alignment mark 50.

For example, the hole inspecting system 100 may perform affine transformation on the plurality of divided images based on the global marks 41, 42, and 43 and the alignment mark 50, may merge the images so that the images are matched with the CAD, and thus may acquire the image of the entire substrate 10.

The hole inspecting system 100 of the present invention may allow the line camera to reciprocate in the first direction x1, move the substrate 10 in the second direction x2, and acquire the image of the entire substrate 10. Thus, an inspection time can be shortened, and the inspection can easily be performed even when the substrate 10 having any size is used.

Although the embodiments of the present invention have been described in more detail with reference to the accompanying drawings, the present invention is not limited to these embodiments and may be variously modified and implemented without departing from the technical spirit of the present invention. Thus, the embodiments disclosed in the present invention are not intended to limit the technology spirit of the present invention, but are intended to describe the present invention, and the scope of the technical spirit of the present invention is not limited by these embodiments. Therefore, it should be understood that the embodiments described above are illustrative but not limiting in all aspects. The scope of protection of the present invention should be interpreted by the appended claims, and all technical spirit within an equivalent scope should be interpreted as being included in the scope of the present invention.

## Claims

1. A hole inspecting system for a substrate provided with a via hole, the hole inspecting system comprising:
a substrate support device that supports the substrate;
a camera disposed above or below the substrate to acquire an image of the substrate;
a coaxial light source disposed at the same side as the camera based on the substrate;
a wide area light source that is disposed at a side opposite to the camera and radiates light onto a wider area than that of the coaxial light source; and
an inspection module that inspects the via hole based on the image of the substrate acquired by the camera.

2. The hole inspecting system of claim 1, further comprising a camera moving module that supports the camera while the camera is spaced a predetermined distance from the substrate and allows the camera to reciprocate in a first direction parallel to the substrate,
wherein the substrate support device further includes a substrate moving module that is parallel to the substrate and moves the substrate in a second direction perpendicular to the first direction.

3. The hole inspecting system of claim 2, wherein the substrate moving module includes a plurality of linear driving modules that are arranged at both sides of the substrate and linearly move the substrate.

4. The hole inspecting system of claim 1, wherein the wide area light source includes a line light source installed to extend to be parallel to a first direction in which the camera reciprocates.

5. The hole inspecting system of claim 4, wherein the line light source radiates light onto an area that is (a length corresponding to a width of the substrate)*(a width corresponding to an FOV of the camera).

6. The hole inspecting system of claim 1, wherein the wide area light source includes a surface light source that radiates light onto an area corresponding to an entire area of the substrate.

7. The hole inspecting system of claim 1, wherein the inspection module includes an image processing unit that processes the image of the substrate based on a global mark corresponding to one point of the substrate and an alignment mark corresponding to each corner of one group formed by the via hole.

8. The hole inspecting system of claim 7, wherein the image processing unit inspects at least one of a position of the one group and a position of the hole included in the one group based on the global mark and the alignment mark.

9. The hole inspecting system of claim 7, wherein the global mark and the alignment mark are formed by radially arranging a plurality of points or circles, and
the image processing unit corrects the image of the substrate by determining whether the image of the substrate is distorted based on the global mark and the alignment mark.

10. The hole inspecting system of claim 7, wherein the camera acquires a plurality of images obtained by dividing the substrate into predetermined areas, and
the image processing unit acquires an image of the entire substrate by merging the plurality of divided images based on the global mark and the alignment mark.

11. The hole inspecting system of claim 10, wherein the image processing unit performs affine transformation on the plurality of divided images based on the global mark and the alignment mark, merges the images to match with a computer-aided design (CAD), and thus acquires the image of the entire substrate.

12. The hole inspecting system of claim 1, wherein the camera acquires the image of the substrate including both an inner diameter and an outer diameter of the via hole, and
the inspection module determines whether the via hole is good based on the image of the substrate.

13. The hole inspecting system of claim 1, wherein, in the image of the substrate, a difference between gray levels inside and outside a boundary area of an inner diameter is 10 or more.

14. A hole inspecting method, which is performed by the hole inspecting system of claim 1, the hole inspecting method comprising:
radiating light onto a substrate using a coaxial light source disposed at the same side as a camera based on the substrate and a wide area light source that is disposed at a side opposite to the camera and radiates light onto a wider area than that of the coaxial light source;
acquiring an image of the substrate using the camera; and
inspecting a via hole based on the acquired image of the substrate.

15. The hole inspecting method of claim 14, wherein the inspecting includes:
correcting the image of the substrate based on a global mark corresponding to one point of the substrate and an alignment mark corresponding to each corner of one group formed by the via hole; and
inspecting whether the via hole is good based on the corrected image of the substrate.
